# EUROPEAN PATENT APPLICATION

(11) **EP 3 483 934 A1**
(43) Date of publication of application: **15.05.2019**
(21) Application number: 18204988.2
(22) Date of filing: 07.11.2018
(51) Int. Cl.: H01L 25/075

(54) **LAMP FOR VEHICLE**

(30) Priority: 09.11.2017 KR 20170148975
(71) Applicant: LG Electronics Inc., Seoul 07336 (KR)
(72) Inventor: KIM, Yongkyo, 07336 Seoul (KR); CHO, Hankyu, 07336 Seoul (KR); YOON, Shinwoo, 07336 Seoul (KR)
(74) Representative: Vossius & Partner Patentanwälte Rechtsanwälte mbB

(57) **Abstract**

Disclosed is a lamp for a vehicle, which comprises an array module in which a plurality of micro Light Emitting Diode (LED) chips are disposed, wherein the array module comprises a plurality of micro LED pairs, and wherein the plurality of micro LED pairs comprises: a first micro LED chip; and a second micro LED chip having electrodes, one of which is in direct contact with one of electrodes in the first micro LED chips.

## Description

### CROSS-REFERENCE TO RELATED APPLICATION

This application claims the priority benefit of Korean Patent Application No. 10-2017-0148975, filed on November 9, 2017 in the Korean Intellectual Property Office, the disclosure of which is incorporated herein by reference.

### BACKGROUND OF THE INVENTION

### 1. Field of the invention

The present invention relates to a lamp for a vehicle, and the lamp.

### 2. Description of the Related Art

A vehicle is an apparatus that moves in a direction desired by a user riding therein. A representative example of a vehicle may be an automobile.

The vehicle includes various lamps. For example, the vehicle includes a head lamp, a rear combination lamp, and a fog lamp.

Such lamps for vehicle may be classified as lamps for securing visibility for a driver (e.g., a head lamp and a fog lamp), and lamps for notifying a simple signal (e.g., a rear combination lamp).

Various devices may be used as light sources of the lamps provided in a vehicle.

Recently, there have been efforts to utilize a plurality of micro Light Emitting Diode (LED) chips as light sources of the lamps for vehicle.

Meanwhile, a plurality of micro LED chips according to an existing technology is not suitable for the lamp for the vehicle to secure a sufficient amount.

### SUMMARY OF THE INVENTION

The present invention has been made in view of the above problems, and it is one object of the present invention to provide a lamp for a vehicle, which is capable of securing a sufficient amount of light using a plurality of micro Light Emitting Device (LED) chips.

It is another object of the present invention to provide a vehicle including the lamp.

Objects of the present invention should not be limited to the aforementioned objects and other unmentioned objects will be clearly understood by those skilled in the art from the following description.

The aforementioned objects are achieved by the independent claim. Dependent claims refer to preferred embodiments.

In accordance with an embodiment of the present invention, there is provided a lamp for a vehicle, which comprises an array module in which a plurality of micro Light Emitting Diode (LED) chips are disposed, wherein the array module comprises a plurality of micro LED pairs, and wherein the plurality of micro LED pairs comprises: a first micro LED chip; and a second micro LED chip having electrodes, one of which is in direct contact with one of electrodes in the first micro LED chips.

The present invention relates to a lamp for a vehicle, the lamp comprising an array module, wherein the array module comprises a plurality of micro Light Emitting Diode, LED, pairs, and wherein each of the plurality of micro LED pairs comprises a first micro LED chip; and a second micro LED chip having electrodes, one of which is in direct contact with one of electrodes in the first micro LED chips.

Preferably, the first micro LED chip comprises a first positive electrode and a first negative electrode.

Preferably, the second micro LED chip comprises a second positive electrode and a second negative electrode.

Preferably, the second positive electrode is in direct contact with one of the first positive electrode and the first negative electrode, or the second negative electrode is in direct contact with one of the first positive electrode and the first negative electrode.

Preferably, the first positive electrode is positioned on a stepped portion which is at a first distance from the first negative electrode in a first direction (height) of the first micro LED chip.

Preferably, the second positive electrode is positioned on a stepped portion which is at the first distance from the second negative electrode in a first direction (height) of the second micro LED chip.

Preferably, the first distance is half a length (height) of the first micro LED chip in the first direction (height), and half a length (height) of the second micro LED chip in the first direction (height).

Preferably, an arranged pattern of the plurality of micro LED pairs is determined based on a shape of the plurality of micro LED pairs.

Preferably, the array module further comprises a base on which the plurality of micro LED pairs is disposed.

Preferably, the plurality of micro LED pairs comprises a first micro LED pair; and a second micro LED pair.

Preferably, the second micro LED pair is disposed on the base in a direction diagonal to the first micro LED pair.

Preferably, the array module further comprises a wire connected to the plurality of micro LED pairs.

Preferably, the wire comprises a sub-wire connected to each of the plurality of micro LED pairs and a main wire connected to the sub-wire.

Preferably, the sub-wire extends in a longitudinal direction or a lateral direction of each of the plurality of micro LED pairs.

Preferably, the main wire extends in parallel with a virtual line which connects first vertices of the plurality of micro LED pairs.

Preferably, the array module comprises a first group of micro LED pairs and a second group of micro LED pairs.

Preferably, an interval between micro LED pairs in the first group is smaller than an interval between the first group of LED pairs and the second group of micro LED pairs.

Preferably, the array module comprises a first array on which the plurality of micro LED pairs is disposed and a second array on which a plurality of micro LED chips is disposed.

Preferably, an arranged pattern of the plurality of micro LED chips on the second array is determined based on an arranged pattern of the plurality of micro LED pairs.

Preferably, the plurality of micro LED chips on the second array is disposed not to overlap the plurality of LED pairs disposed on the first array in a direction of light emission.

Preferably, any one of the plurality of micro LED chips disposed on the second array is connected in series to at least one of the plurality of micro LED pairs disposed on the first array.

Preferably, the plurality of micro LED pairs disposed on the first array is connected to a first positive electrode wire and a first negative electrode wire.

Preferably, the plurality of micro LED chips disposed on the second array is connected to a second positive electrode wire and a second negative electrode wire.

Preferably, each of the plurality of micro LED pairs disposed on the first array comprises a first electrode and a second electrode.

Preferably each of the plurality of micro LED chips disposed on the second array comprises a first electrode and a second electrode.

Preferably the second electrode of the respective micro LED chip is located underneath a bottom surface of the respective micro LED chip disposed on the second array.

Preferably the array module comprises a first insulation layer which is disposed between the first electrode of the respective micro LED chip and the second electrode of the respective micro LED chip in a direction of light emission.

Preferably the array module further comprises a second insulation layer which is disposed between the first insulation layer and the second electrode of the respective micro LED pair in the direction of light emission, and which is formed of a transparent material.

Preferably the array module further comprises a third insulation layer which is disposed between the second insulation layer and the first electrode of the respective micro LED pair in the direction of light emission, and which is formed of a transparent material.

Preferably, the first insulation layer is formed of an opaque material.

Preferably, the array module further comprises a reflective layer disposed on the first insulation layer.

Preferably, the array module further comprises a reflective layer disposed on the first insulation layer.

Preferably, the first insulation layer is formed of a transparent material.

Preferably, the array module comprises a first micro LED pair and a second micro LED pair.

Preferably, the first micro LED pair and the second micro LED pair are disposed such that electrodes of the same type face each other.

Preferably, the array module further comprises a partition structure which surrounds each of the plurality of micro LED pairs in all directions to guide light generated by the plurality of micro LED pairs.

Preferably, the array module further comprises a phosphor which is coated inside a space defined by the partition structure.

Preferably, the array module further comprises an insulator disposed below the plurality of micro LED pairs.

Preferably, the insulator comprises at least one hole which accommodates a metal material.

The details of other embodiments are included in the following description and the accompanying drawings.

The embodiments of the present invention have one or more effects as follows.

First, it is possible to secure a sufficient amount of light using a plurality of micro LEDs.

Second, the plurality of micro LEDs can be controlled on the basis of a predetermined unit, and thus, it is possible to realize various light outputting effects.

Third, intervention by a wire on an optical path can be minimized, thereby increasing optical efficiency.

Effects of the present invention should not be limited to the aforementioned effects and other unmentioned effects will be clearly understood by those skilled in the art from the claims.

### BRIEF DESCRIPTION OF THE DRAWINGS

The embodiments will be described in detail with reference to the following drawings in which like reference numerals refer to like elements wherein:
FIG. 1 is a diagram illustrating the exterior appearance of a vehicle according to an embodiment of the present invention;
FIG. 2 is a block diagram illustrating a lamp for a vehicle according to an embodiment of the present invention;
FIGS. 3A to 3C are diagrams illustrating a lamp for a vehicle according to an embodiment of the present invention;
FIG. 4 is a diagram illustrating an array in which a plurality of micro LED chips is arranged, according to an embodiment of the present invention;
FIG. 5 is a diagram illustrating an array in which micro LED chips are arranged, according to an embodiment of the present invention;
FIG. 6 is a diagram illustrating an array module according to an embodiment of the present invention;
FIG. 7A is an example of a top view of an integrated array module according to an embodiment of the present invention;
FIG. 7B is an example of a side view of an integrated array module according to an embodiment of the present invention;
FIG. 8 is a diagram illustrating an array module in which a plurality of micro LED chips is arranged, according to an embodiment of the present invention;
FIGS. 9A and 9B are diagrams illustrating a micro LED pair according to an embodiment of the present invention;
FIG. 10 is a diagram illustrating a micro LED pair according to an embodiment of the present invention;
FIGS. 11A to 12B are diagrams illustrating an arranged pattern of a plurality of micro LED pairs, and wires therefor according to an embodiment of the present invention;
FIGS. 13 to 15 are diagrams illustrating an array module according to an embodiment of the present invention;
FIG. 16 is a diagram illustrating an example of how a plurality of micro LED pairs and electrodes of a plurality of micro LED chips are disposed, according to an embodiment of the present invention;
FIGS 17A to 17C are diagrams illustrating an array module according to an embodiment of the present invention;
FIGS. 18A to 18D are diagrams illustrating an array module according to an embodiment of the present invention; and
FIGS. 19A to 19D are diagrams illustrating an array module according to an embodiment of the present invention.

### DETAILED DESCRIPTION OF THE EMBODIMENTS

Hereinafter, the embodiments disclosed in the present specification will be described in detail with reference to the accompanying drawings, and the same or similar elements are denoted by the same reference numerals even though they are depicted in different drawings and redundant descriptions thereof will be omitted. In the following description, with respect to constituent elements used in the following description, the suffixes "module" and "unit" are used or combined with each other only in consideration of ease in the preparation of the specification, and do not have or serve as different meanings. Accordingly, the suffixes "module" and "unit" may be interchanged with each other. In addition, in the following description of the embodiments disclosed in the present specification, a detailed description of known functions and configurations incorporated herein will be omitted when it may make the subject matter of the embodiments disclosed in the present specification rather unclear. In addition, the accompanying drawings are provided only for a better understanding of the embodiments disclosed in the present specification and are not intended to limit the technical ideas disclosed in the present specification. Therefore, it should be understood that the accompanying drawings include all modifications, equivalents and substitutions included in the scope and sprit of the present invention.

It will be understood that although the terms "first," "second," etc., may be used herein to describe various components, these components should not be limited by these terms. These terms are only used to distinguish one component from another component.

It will be understood that when a component is referred to as being "connected to" or "coupled to" another component, it may be directly connected to or coupled to another component or intervening components may be present. In contrast, when a component is referred to as being "directly connected to" or "directly coupled to" another component, there are no intervening components present.

As used herein, the singular form is intended to include the plural forms as well, unless the context clearly indicates otherwise.

In the present application, it will be further understood that the terms "comprises", includes," etc. specify the presence of stated features, integers, steps, operations, elements, components, or combinations thereof, but do not preclude the presence or addition of one or more other features, integers, steps, operations, elements, components, or combinations thereof.

A vehicle as described in this specification may include an automobile and a motorcycle. Hereinafter, a description will be given based on an automobile.

A vehicle as described in this specification may include all of an internal combustion engine vehicle including an engine as a power source, a hybrid vehicle including both an engine and an electric motor as a power source, and an electric vehicle including an electric motor as a power source.

In the following description, "the left side of the vehicle" refers to the left side in the forward driving direction of the vehicle, and "the right side of the vehicle" refers to the right side in the forward driving direction of the vehicle.

In the following description, an array module 200m may include one or more arrays.

The array module 200m may include one or more layers, and one array may be disposed on one layer.

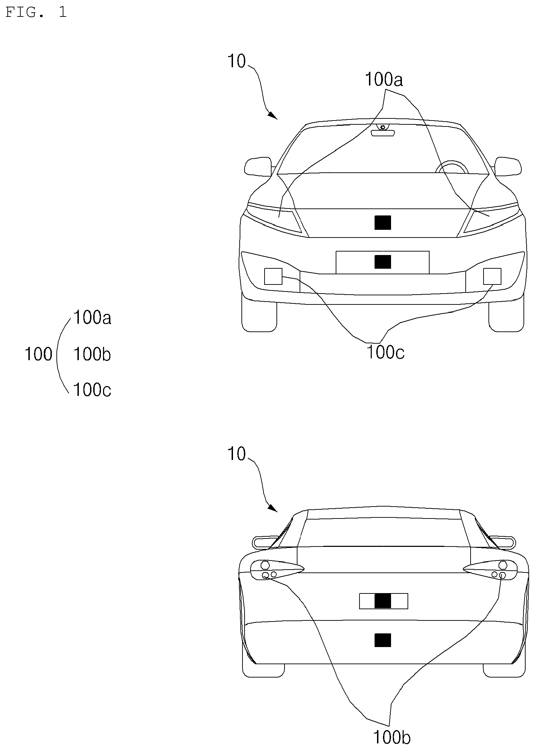

FIG. 1 is a diagram illustrating the exterior appearance of a vehicle according to an embodiment of the present invention.

Referring to FIG. 1, a vehicle 10 may include a lamp 100.

The lamp 100 may include a head lamp 100a, a rear combination lamp 100b, and a fog lamp 100c.

The lamp 100 may further include a room lamp, a turn signal lamp, a daytime running lamp, a back lamp, a positioning lamp, etc.

Meanwhile, the term "overall length" means the length from the front end to the rear end of the vehicle 100, the term "overall width" means the width of the vehicle 100, and the term "overall height" means the height from the bottom of the wheel to the roof. In the following description, the term "overall length direction L" may mean the reference direction for the measurement of the overall length of the vehicle 100, the term "overall width direction W" may mean the reference direction for the measurement of the overall width of the vehicle 100, and the term "overall height direction H" may mean the reference direction for the measurement of the overall height of the vehicle 100.

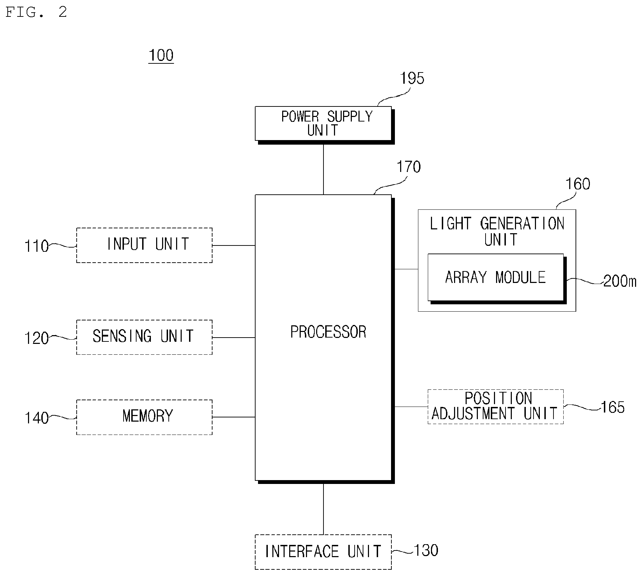

FIG. 2 is a block diagram illustrating a lamp for a vehicle according to an embodiment of the present invention.

Referring to FIG. 2, the lamp 100 may include a light generation unit 160, a processor 170, and a power supply unit 190.

The lamp 100 may further include an input unit 110, a sensing unit 120, an interface unit 130, a memory 140, and a position adjustment unit 165 individually or in combination thereof.

The input unit 110 may receive a user input for controlling the lamp 100.

The input unit 110 may include one or more input devices. For example, the input unit 110 may include at least one of a touch input device, a mechanical input device, a gesture input device, and a sound input device.

The input unit 110 may receive a user input for controlling operation of the light generation unit 160.

For example, the input unit 110 may receive a user input for turning on or off the light generation unit 160.

The sensing unit 120 may include one or more sensors.

For example, the sensing unit 120 may include either or both of a temperature sensor and an illumination sensor.

The sensing unit 120 may acquire temperature information of the light generation unit 160.

The sensing unit 120 may acquire illumination information about the outside of the vehicle 10.

The interface unit 130 may exchange information, data, or a signal with another device provided in the vehicle 10.

The interface unit 130 may transmit at least one of information, data, and a signal, received from another device provided in the vehicle 10, to the processor 170.

The interface unit 130 may transmit at least one of information, data, and a signal, generated by the processor 170, to another device provided in the vehicle 10.

The interface unit 130 may receive driving situation information.

The driving situation information may include at least one of the following: information about an object outside the vehicle 10, navigation information, and vehicle state information.

The information about an object outside the vehicle 10 may include the following: information about the presence of the object, information about a location of the object, information about movement of the object, information about a distance between the vehicle 10 and the object, information about a relative speed between the vehicle 10 and the object, and information about a type of the object.

The information about the object may be generated by an object detection apparatus provided in the vehicle 10. The object detection apparatus may detect an object based on sensing data generated by one or more of a camera, a radar, a lidar, an ultrasonic sensor, and an infrared sensor.

The object may include a line, another vehicle, a pedestrian, a two-wheeled vehicle, a traffic sign, light, a road, a structure, a bump, a geographic feature, an animal, etc.

The navigation information may include at least one of the following: map information, information on a set destination, information on a route to the set destination, and information on various object located along the route, lane information, and information on the current location of the vehicle 10.

The navigation information may be generated by a navigation device provided in the vehicle 10.

The vehicle state information may include at least one of the following: vehicle position information, vehicle speed information, vehicle tilt information, vehicle weight information, vehicle direction information, vehicle battery information, vehicle fuel information, vehicle tire pressure information, vehicle steering information, in-vehicle temperature information, in-vehicle humidity information, pedal position information, vehicle engine temperature information, etc.

The vehicle state information may be generated based on sensing information about any of various sensors provided in the vehicle 10.

The memory 140 may store basic data for each unit of the lamp 100, control data for the operational control of each unit of the lamp 100, and input/output data of the lamp 100.

The memory 140 may be any of various hardware storage devices, such as a ROM, a RAM, an EPROM, a flash drive, and a hard drive.

The memory 140 may store various data for the overall operation of the lamp 100, such as programs for the processing or control of the processor 170.

The memory 140 may be classified as a sub-element of the processor 170.

The light generation unit 160 may convert electrical energy into light energy under the control of the processor 170.

The light generation unit 160 may include an array module 200m in which multiple groups of micro Light Emitting Diode (LED) chips are arranged.

The array module 200m may be formed flexible.

For example, the array 200 may be formed flexible in a manner such that a Flexible Copper Clad Laminated (FCCL) substrate is disposed on a polyimide (PI) layer and then LED chips each few micrometers (um) are transferred onto the FCCL substrate.

The array module 200m may include one or more micro LED arrays 200.

In some embodiments, the array module 200m may be formed such that a plurality of arrays are deposited on each other.

The multiple groups of micro LED chips may have different shapes.

A micro LED chip may be referred to as a micro LED light emitting device package.

A micro LED chip may include a light emitting device.

A micro LED chip may be of a few micrometers (um). For example, a micro LED chip may be 5-15um.

A light emitting device of a micro LED chip may be transferred onto a substrate.

The array 200 may include a substrate, and a subarray in which a plurality of micro LED chips are arranged. In the array, one or more subarrays may be provided.

The subarray may have any of various shapes.

For example, the subarray may be in the shape of a figure of a predetermined area.

For example, the subarray may be in the shape of a circle, a polygon, a fan, etc.

It is desirable that the substrate include an FCCL substrate.

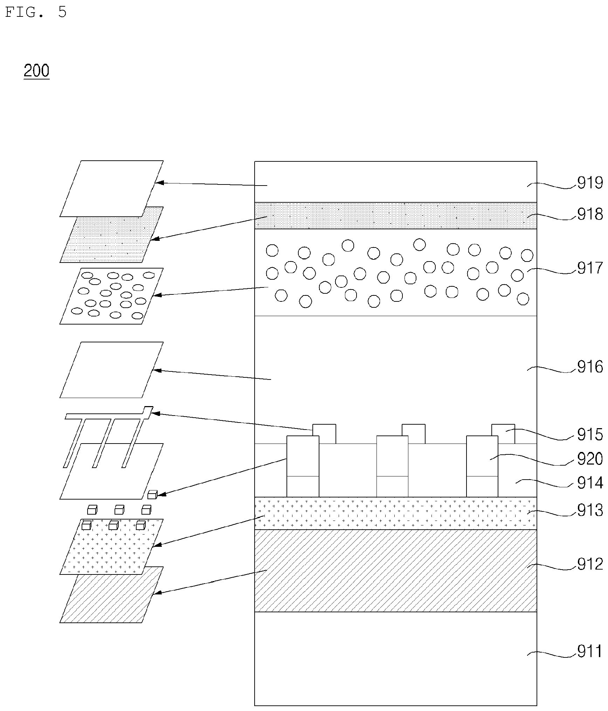

For example, a base 911 (see FIG. 5) and a first electrode 912 (see FIG. 5) may make up the substrate.

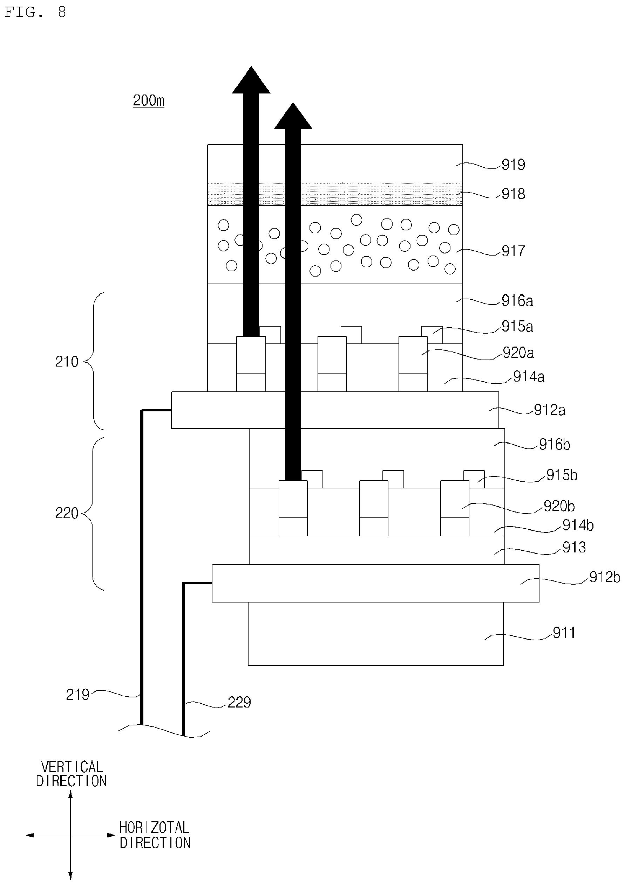

For example, a base 911 (see FIG. 8) and a second anode 912b (see FIG. 8) may make up a substrate.

The position adjustment unit 165 may adjust position of the light generation unit 160.

The position adjustment unit 165 may control the light generation unit 160 to be tilted. Due to the tilting control of the light generation unit 160, an output light may be adjusted in an upward-downward direction (e.g., an overall height direction).

The position adjustment unit 165 may control the light generation unit 160 to be panned. Due to the panning control of the light generation unit 160, an output light may be adjusted in a left-right direction (e.g., an overall width direction).

The position adjustment unit 165 may further include a driving force generation unit (e.g., a motor, an actuator, and a solenoid) which provides a driving force required to adjust a position of the light generation unit 160.

When the light generation unit 160 generates a low beam, the position adjustment unit 165 may adjust a position of the light generation unit 160 so that the light generation unit 160 outputs a light downward further than when generating a high beam.

When the light generation unit 160 generates a high beam, the position adjustment unit 165 may adjust a position of the light generation unit 160 so that the light generation unit 160 outputs a light upward further than when generating a low beam.

The processor 170 may be electrically connected to each unit of the lamp 100. The processor 170 may control overall operation of each unit of the lamp 100.

The processor 170 may control the light generation unit 160.

The processor 170 may control the light generation unit 160 by adjusting an amount of electrical energy to be supplied to the light generation unit 160.

The processor 170 may control the array module 200m on the basis of each region.

For example, the processor 170 may control the array module 200m on the basis of each region by supplying a different amount of electrical energy to micro LED chips arranged in each region of the array module 200m.

The processor 170 may control the array module 200m on the basis of each layer.

A plurality of layers in the array module 200m may be composed of a plurality of arrays 200.

For example, the processor 170 may control the array module 200m on the basis of each layer by supplying a different amount of electrical energy to each layer.

Under the control of the processor 170, the power supply unit 190 may supply electrical energy required to operate each unit of the lamp 100. In particular, the power supply unit 190 may be supplied with power from a battery inside the vehicle 10.

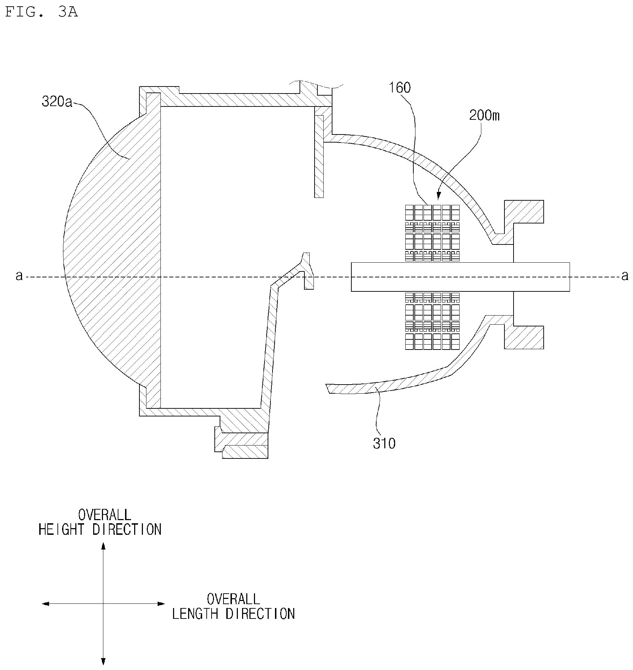

FIGS. 3A to 3C are diagrams illustrating a lamp for a vehicle according to an embodiment of the present invention.

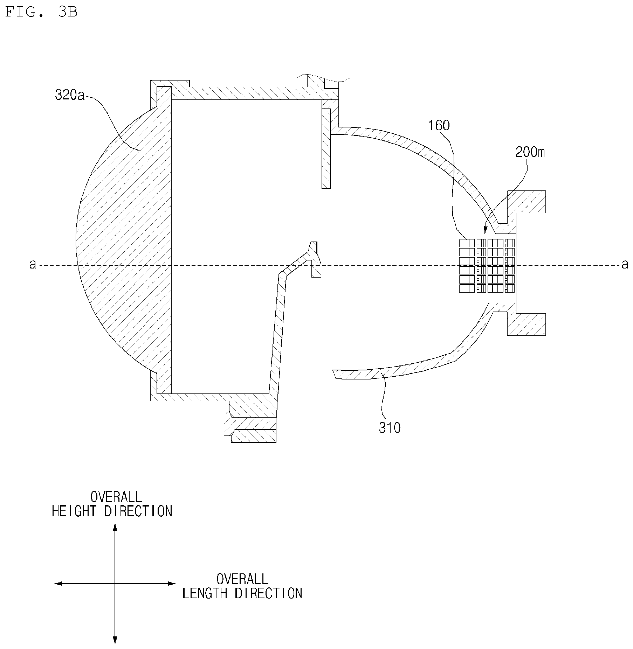

FIGS. 3A and 3B are examples of a cross-sectional view of the lamp 100 implemented as a head lamp 100a.

Referring to FIGS. 3A and 3B, the lamp 100 may include a light generation unit 160, a reflector 310, and a lens 320a.

The reflector 310 may reflect light generated by the light generation unit 160. The reflector 310 may guide light to be emitted forward or rearward of the vehicle 10.

The reflector 310 may be formed of a highly reflective material, such as aluminum (AL) and silver (Ag), or may be coated on a reflective surface.

The lens 320a may be disposed before the light generation unit 160 and the reflector 310. The lens 320a may refract light generated by the light generation unit 160 or light reflected by the reflector 310, and allow the refracted light to pass therethrough. The lens 320a may be an aspheric lens.

The lens 320a may change an optical path of light generated by the light generation unit 160.

The lens 320a may be formed of a transparent synthetic resin or glass.

As illustrated in FIG. 3A, the light generation unit 160 may output light in an overall height direction.

As illustrated in FIG. 3B, the light generation unit 160 may output light in an overall length direction.

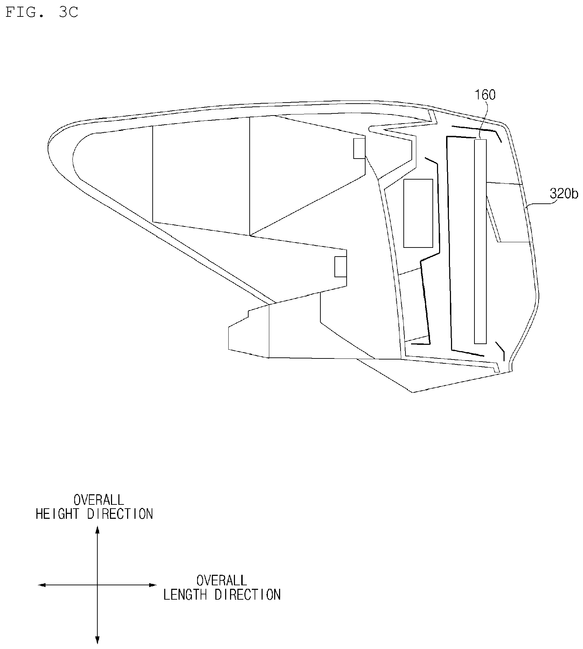

FIG. 3C is a diagram illustrating a lamp for a vehicle according to an embodiment of the present invention.

FIGS. 3C is an example of a cross-sectional view of the lamp 100 implemented as a rear combination lamp 200b.

Referring to FIG. 3C, the lamp 100 may include a light generation unit 160 and a lens 320b.

The lens 320b may cover the light generation unit 160. The lens 320b may refract light generated by the light generation unit 160, and allow the refracted light to pass therethrough. The lens 320b may be an aspheric lens.

The lens 320b may change an optical path of light generated by the light generation unit 160.

The lens 320b may be formed of a transparent synthetic resin or glass.

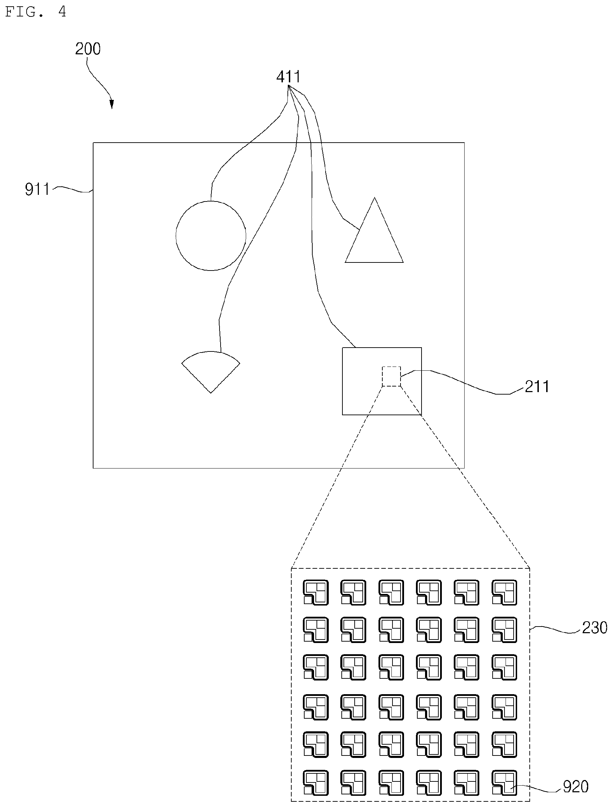

FIG. 4 is a diagram illustrating an array in which a plurality of micro LED chips is arranged, according to an embodiment of the present invention.

Referring to FIG. 4, a plurality of micro LED chips 920 may be disposed on an array 200.

The plurality of micro LED chips 920 may be transferred onto the array 200.

An interval between micro LED chips 920 on the flexible array 200, and a density of micro LED chips 920 (that is, the number of micro LED chips per unit area) on the flexible array 200 may be determined depending on a transfer interval.

The array 200 may include a plurality of sub-arrays 411 in which different groups of micro LED chips are arranged respectively.

The array 200 may include a base 911 and one or more sub-arrays 411.

The base 911 may be formed of a material such as a polyimide (PI).

In some embodiments, the base 911 may be a concept including a polyimide layer and an FCCL substrate disposed on the polyimide layer.

Each of the sub-arrays 411 may be disposed on the base 911.

A plurality of micro LED chips 920 may be disposed on each of the sub-arrays 411.

The sub-array 411 may be generated by cutting a main array which is an FCCL substrate on which a plurality of micro LED chips 920 is disposed.

In this case, the shape of the sub-array 411 may be determined by a cut shape of the main array.

For example, the sub-array 411 may be in the shape of a two-dimensional figure (e.g., a circle, a polygon, and a fan) .

FIG. 5 is a diagram illustrating an array in which micro LED chips are arranged, according to an embodiment of the present invention.

Referring to FIG. 5, the array 200 may include a polyimide layer 911, a FCC substrate 912, a reflective layer 913, an inter-layer dielectric film 914, a plurality of micro LED chips 920, a second electrode 915, an optical spacer 916, a phosphor layer 917, a color filter film 918, and a cover film 919.

The polyimide layer 911 may be formed flexible.

The FCCL substrate 912 may be formed of copper. The FCCL substrate 912 may be referred to as a first electrode.

In some embodiments, the polyimide layer 911 may be referred to as a base.

The first electrode and the second electrode may be electrically connected to the plurality of micro LED chips 920 so as to supply power thereto.

The first electrode 912 and the second electrode 915 may be light transmissive electrodes.

The first electrode 912 may be an anode.

The second electrode 915 may be a cathode.

The first electrode 912 and the second electrode 915 may a metal material which is one or a combination of the following: nickel (Ni), platinum (Pt), ruthenium (Ru), iridium (Ir), rhodium (Rh), tantalum (Ta), molybdenum (Mo), titan (Ti), silver (Ag), tungsten (W), copper (Cu), chromium (Cr), palladium (Pd), vanadium (V), cobalt (Co), niobium (Nb), zirconium (Zr), indium tin oxide (ITO), aluminum zinc oxide (AZO) and Indium Zinc Oxide (IZO).

The first electrode 912 may be formed between the polyimide film 911 and the reflective layer 913.

The second electrode 915 may be formed on the inter-layer dielectric film 914.

The reflective layer 913 may be formed on the FCCL substrate 912. The reflective layer 913 may reflect light generated by the plurality of micro LED chips 920. It is desirable that the reflective layer 913 may be formed of silver Ag.

The inter-layer dielectric film 914 may be formed on the reflective layer 913.

The plurality of micro LED chips 920 may be formed on the FCCL substrate 912. Each of the plurality of micro LED chips 920 may be attached to the reflective layer 913 or the FCCL substrate 912 using a solder material or an Anisotropic Conductive Film (ACF).

Meanwhile, a micro LED chip 920 may be an LEC chip of 10-100*µ*m.

The optical spacer 916 may be formed on the inter-dielectric layer 914. The optical spacer 916 may be used to keep a distance between the plurality of micro LED chips 920 and the phosphor layer 917, and may be formed of an insulating material.

The phosphor layer 917 may be formed on the optical spacer 916. The phosphor layer 917 may be formed of resin in which a phosphor is evenly distributed. Depending on a wavelength of light emitted from a micro LED chips 920, any one selected from a blue light-emitting phosphor, a blue-green light-emitting phosphor, a green light-emitting phosphor, a yellow-green light-emitting phosphor, a yellow light-emitting phosphor, a yellow-red light-emitting phosphor, an orange light-emitting phosphor, and a red light-emitting phosphor may be applied as the phosphor.

That is, a phosphor may be excited by a light having a first color, which is emitted from the micro LED chips 920, to thereby generate a light having a second color.

The color film 918 may be formed on the phosphor layer 917. The color filter film 918 may realize a specific color for light which has passed the phosphor layer 917. The color filter film 918 may realize at least one or a combination of red (R), green (G), and blue (B).

The cover film 919 may be formed on the color filter film 918. The cover film 919 may protect the array 200.

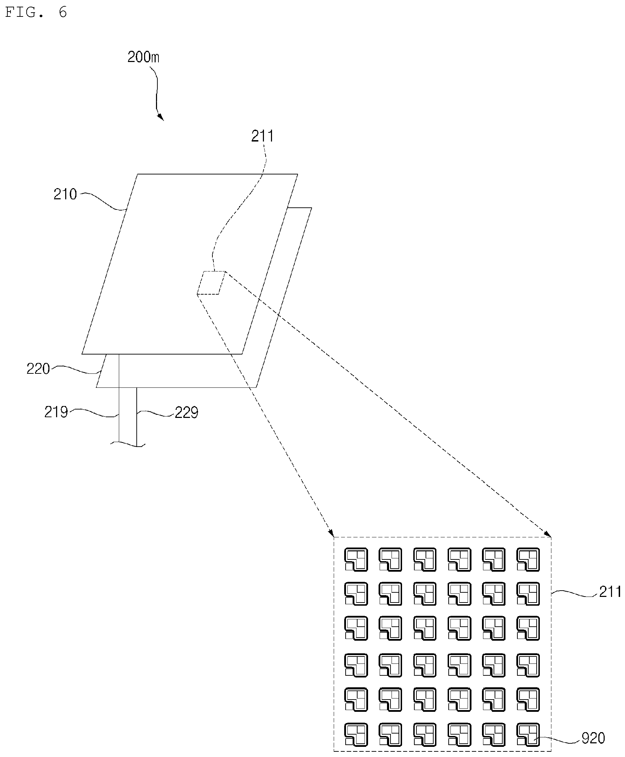

FIG. 6 is a diagram illustrating an array module according to an embodiment of the present invention.

Referring to FIG. 6, the light generation unit 160 may include an array module 200m including a plurality of arrays.

For example, the light generation unit 160 may include a first array 210 and a second array 220.

The first array 210 may be different from the second array 220 in terms of at least one of the following: an interval between a plurality of micro LED chips, positions of the plurality of micro LED chips, and a density of the plurality of micro LED chips.

The second array 220 may be different from the first array 210 in terms of at least one of the following: an interval between a plurality of micro LED chips, positions of the plurality of micro LED chips, and a density of the plurality of micro LED chips.

The density of the plurality of micro LED chips indicates the number of micro LED chips per unit area.

A first group of micro LED chips may be disposed on the first array 210 in a first pattern.

The first pattern may be determined by at least one of the following: an interval between micro LED chips in the first group, positions of the micro LED chips in the first group on an array module, and a density of the micro LED chips in the first group.

A plurality of micro LED chips included in the first array 210 may be disposed at a first interval.

A plurality of micro LED chips included in the first group may be disposed at the first interval.

The second array 210 may be configured such that the plurality of micro LED chips included in the second group is disposed in a second pattern which is different from the first pattern.

The second pattern may be determined by at least one of the following: an interval between the micro LED chips in the second group, positions of the micro LED chips in the second group, and a density of the micro LED chips in the second group.

The plurality of micro LED chips included in the second array 220 may be disposed at an interval as the same as the interval at which the plurality of micro LED chips included in the first array 210 is disposed.

The plurality of micro LED chips included in the second group may be disposed at an interval as the same as the interval at which the plurality of micro LED chips included in the first group is disposed.

That is, the plurality of LED chips included in the second group may be disposed at the first interval.

The plurality of micro LED chips included in the second group may be disposed not to overlap the plurality of micro LED chips included in the first group in a vertical or horizontal direction.

For example, the first group of micro LED chips may be disposed on the first array 210 not to overlap the second group of micro LED chips, when viewed from above with the first array 210 and the second array 220 overlapping each other.

For example, the second group of micro LED may be disposed on the second array 220 not to overlap the first group of micro LED chips, when viewed from above with the second array 220 and the first array 210 overlapping each other.

Due to such arrangement, it is possible to minimize intervention of the micro LED chips belonging to the first group in output power from the micro LED chips belonging to the second group.

In some embodiments, the light generation unit 160 may include three or more arrays.

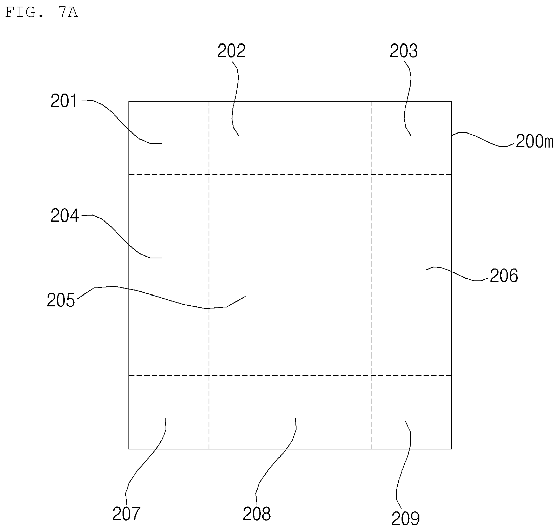

FIG. 7A is an example of a top view of an integrated array module according to an embodiment of the present invention.

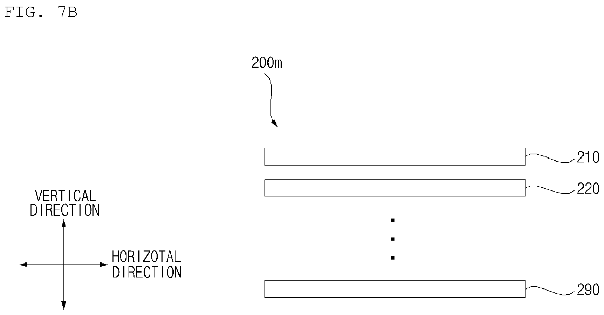

FIG. 7B is an example of a side view of an integrated array module according to an embodiment of the present invention.

Referring to FIGS. 7A and 7B, the processor 170 may control the array module 200m on the basis of each region (regions 201 to 209).

The processor 170 may adjust a light distribution pattern by controlling the array module 200m on the basis of each region.

The array module 200m may be divided into a plurality of regions 201 to 209.

The processor 270 may adjust an amount of electrical energy to be supplied to each of the plurality of regions 201 to 209.

The processor 170 may control the array module 200m on the basis of each layer.

The processor 270 may adjust an amount of output light by controlling the array module 200m on the basis of each layer.

The array module 200m may be composed of a plurality of layers. The plurality of layers may be composed of a plurality of arrays, respectively.

For example, a first layer of the array module 200m may be formed by a first array, and a second layer of the array module 200m may be formed by a second array.

The processor 270 may adjust an amount of electrical energy to be supplied to each of the plurality of layers.

FIG. 8 is a diagram illustrating an array module in which a plurality of micro LED chips is arranged, according to an embodiment of the present invention.

FIG. 8 shows an example in which the array module 200m includes a first array 210 and a second array 210, but the array module 200m may include three or more arrays.

Referring to FIG. 8, the array module 200m may include a polyimide layer 911, the first array 210, and a second array 220.

In some embodiments, the array module 200m may further include a phosphor layer 917, a color filter film 918, and a cover film 919 individually or in combination thereof.

The polyimide layer 911 may be formed flexible.

The second array 220 may be disposed on the base 911.

In some embodiments, a layer composed of the polyimide layer 911 or a second anode 912b may be referred to as a base.

In some embodiments, the polyimide layer 911 may be referred to as a base.

The second array 220 may be disposed between he first array 210 and the base 911.

The second array 220 may include a second anode 912b, a reflective layer 913, a second inter-layer dielectric film 914b, a second group of micro LED chips 920b, a second optical spacer 916b, and a second cathode 915b.

The second anode 912b may be an FCCL substrate. The second anode 912b may be formed of copper.

The second anode 912b and the second cathode 915b may be light transmissive electrodes.

The second anode 912b and the second cathode 915b may be referred to as transparent electrodes.

The second array 220 may include a transparent electrode.

The second anode 912b and the second cathode 915 may include a metal material which is one or a combination of the following: nickel (Ni), platinum (Pt), ruthenium (Ru), iridium (Ir), rhodium (Rh), tantalum (Ta), molybdenum (Mo), titan (Ti), silver (Ag), tungsten (W), copper (Cu), chromium (Cr), palladium (Pd), vanadium (V), cobalt (Co), niobium (Nb), zirconium (Zr), indium tin oxide (ITO), aluminum zinc oxide (AZO) and Indium Zinc Oxide (IZO).

The second anode 912b may be formed between the base 911 and the reflective layer 913.

The second cathode 915b may be formed on the second inter-dielectric film 914b.

The reflective layer 913 may be formed on the second anode 912b. The reflective layer 913 may reflect light generated by the plurality of micro LED chips 920. It is desirable that the reflective layer 913 may be formed of silver Ag.

The second inter-layer dielectric film 914b may be formed on the reflective layer 913.

The second group of micro LED chips 920b may be formed on the second anode 912b. Each micro LED chip 920b belonging to the second group may be attached to the reflective layer 912 or the second anode 912b using a solder material or an Anisotropic Conductive Film (ACF).

The second optical spacer 916b may be formed on the second inter-layer dielectric film 914b. The optical spacer 916b is used to keep the micro LED chips 920b and the first flexible array 210 at a distance from each other, and the optical spacer 916b may be made of an insulating material.

The first array 210 may be formed on the second array 220.

The first array 210 may include a first anode 912a, a first inter-layer dielectric film 914a, a first group of micro LED chips 920a, a first optical spacer 916a, and a first cathode 915a.

The first anode 912a may be a FCCL substrate. The first anode 912a may be formed of copper.

The first anode 912a and the first cathode 915a may be light transmissive electrodes.

The first anode 912a and the first cathode 915a may be referred to as transparent electrodes.

The first array 210 may include a transparent electrode.

The first anode 912a and the first cathode 915a may include a metal material which is one or a combination of the following: nickel (Ni), platinum (Pt), ruthenium (Ru), iridium (Ir), rhodium (Rh), tantalum (Ta), molybdenum (Mo), titan (Ti), silver (Ag), tungsten (W), copper (Cu), chromium (Cr), palladium (Pd), vanadium (V), cobalt (Co), niobium (Nb), zirconium (Zr), indium tin oxide (ITO), aluminum zinc oxide (AZO) and Indium Zinc Oxide (IZO).

The first anode 912a may be formed between the second optical spacer 916b and the first inter-layer dielectric film 914a.

The first cathode 915a may be formed on the first inter-layer dielectric layer 914a.

The first inter-layer dielectric film 914a may be formed on the first anode 912a.

The first group of micro LED chips 920a may be formed on the first anode 912a. Each micro LED chip 920a belonging to the first group may be attached to the first anode 912a using a solder material or an Anisotropic Conductive Film (ACF).

The first optical spacer 916a may be formed on the first inter-layer dielectric film 914a. The first optical spacer 916a is used to keep a distance between the first group of micro LED chips 920a and the phosphor layer 917, and may be formed of an insulating material.

The phosphor layer 910 may be formed on the first array 210 and the second array 220.

The phosphor layer 917 may be formed on the first optical spacer 916a. The phosphor layer 917 may be formed of resin in which a phosphorus is evenly distributed. Depending on a wavelength of light emitted from the micro LED chips 920a and 920b belonging to the first and second groups, any one selected from a blue light-emitting phosphor, a blue-green light-emitting phosphor, a green light-emitting phosphor, a yellow-green light-emitting phosphor, a yellow light-emitting phosphor, a yellow-red light-emitting phosphor, an orange light-emitting phosphor, and a red light-emitting phosphor may be applied as the phosphor.

The phosphor 917 may change a wavelength of lights emitted from first and second micro LED chips 920a and 920b.

The phosphor 917 may change a wavelength of a first light generated by the first group of micro LED chips 920a, and a wavelength of a second light generated by the second group of micro LED chips 920b.

The color filter film 918 may be formed on the phosphor layer 917. The color filter film 918 may realize a predetermined color for a light which has passed through the phosphor layer 917. The color filter film 918 may realize at least one or a combination of red (R), green (B), and blue (B).

The cover film 919 may be formed on the color filter film 918. The cover film 919 may protect the array module 200m.

Meanwhile, the plurality of micro LED chips 920b included in the second array 220 may be disposed not to overlap the plurality of micro LED chips 920a included in the first array 210 in a vertical or horizontal direction.

The plurality of micro LED chips 920b included in the second group may be disposed not to overlap the plurality of micro LED chips 920a included in the first group in a vertical or horizontal direction.

The vertical direction may be a direction in which the array module 200m is deposited.

The first and second groups of micro LED chips 920a and 920b may output light in the vertical direction.

The horizontal direction may be a direction in which the first and second groups of micro LED chips 920a and 920b are arranged.

The horizontal direction may be a direction in which the base 911, the first and second anodes 912a and 912b, or the phosphor layer 917 extends.

Meanwhile, the lamp 100 may further include a wire for supplying power to the array module 200m.

For example, the lamp 100 may include a first wire 219 and a second wire 229.

The first wire 219 may supply power to the first array 210. The first wire 219 may be a pair of wires. The first wire 219 may be connected to the first anode 912a and/or the first cathode 915a.

The second wire 229 may supply power to the second array 220. The second wire 229 may be a pair of wires. The second wire 229 may be connected to the second anode 912b and/or the second cathode 915b.

The first wire 219 and the second wire 229 may be disposed not to overlap each other.

As described above with reference to FIGS. 1 to 8, the lamp 100 may include the array module 200m in which a plurality of micro LED chips is arranged.

The array module 200m described above with reference to FIGS. 1 to 8 may include a micro LED pair 1000.

Hereinafter, the micro LED pair 1000 will be described with reference to the accompanying drawings.

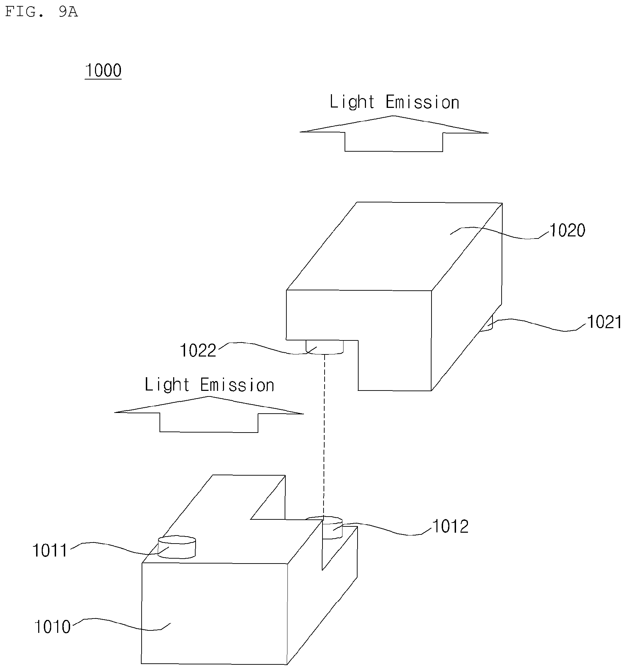

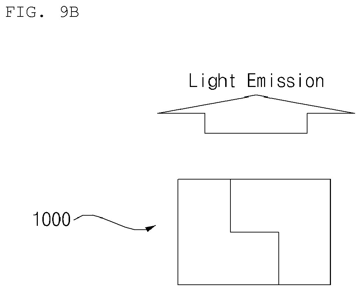

FIGS. 9A and 9B are diagrams illustrating a micro LED pair according to an embodiment of the present invention.

FIG. 9A shows an example of a first micro LED chip 1010 and a second micro LED chip 1020 included in the micro LED pair 1000.

FIG. 9B is a conceptual diagram of the micro LED pair 1000.

Referring to FIGS. 9A and 9B, a plurality of micro LED pairs 1000 may include a first micro LED chip 1010 and a second micro LED chip 1020.

The first micro LED chip 1010 may be a lateral chip.

One of electrodes in the first micro LED chip 1010 may be in direct contact with one of electrodes in the second micro LED chip 1020.

The first micro LED chip 1010 may include a first positive electrode 1011 and a first negative electrode 1012.

The first positive electrode 1011 may be in direct contact with any one of a second positive electrode 1021 and a second negative electrode 1022.

The first negative electrode 1012 may be in direct contact with any one of the second positive electrode 1021 and the second negative electrode 1022.

The second micro LED chip 1020 may be a flip chip or a vertical chip.

One of electrodes in the second micro LED chip 1020 may be in direct contact with one of electrodes in the first micro LED chip 1010.

The second micro LED chip 1020 may include the second positive electrode 1021 and the second negative electrode 1022.

The second positive electrode 1021 may be in direct contact with the first positive electrode 1011 and the first negative electrode 1012.

The second negative electrode 1022 may be in direct contact with the first positive electrode 1011 and the first negative electrode 1012.

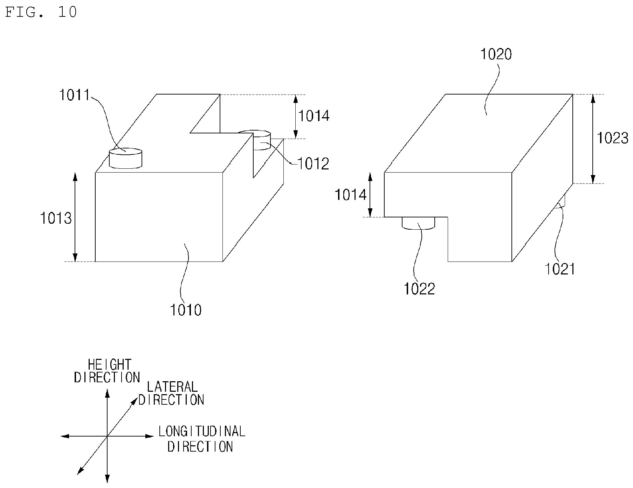

FIG. 10 is a diagram illustrating a micro LED pair according to an embodiment of the present invention.

Referring to FIG. 10, the first positive electrode 1011 may be positioned on a stepped portion which is at a first distance 1014 from the first negative electrode 1012 in a height direction of the first micro LED chip 1010.

The second positive electrode 1021 may be positioned on a stepped portion which is at the first distance 1014 from the second negative electrode 1022 in a height direction of the second micro LED chip 1020.

The first distance 1014 may be half a height 1013 of the first micro LED chip 1010, and half a height 1023 of the second micro LED chip 1020.

No stepped portion is formed between an upper surface and a lower surface a micro LED pair due to the above structure, and this is advantageous in terms of arrangement of a plurality of layers.

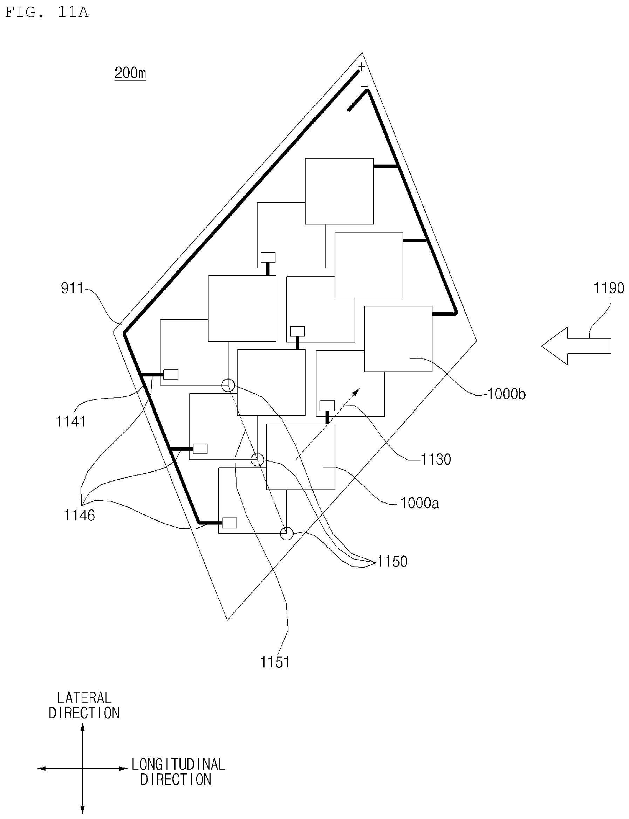

FIGS. 11A to 12B are diagrams illustrating an arranged pattern of a plurality of micro LED pairs, and wires therefor according to an embodiment of the present invention.

The arranged pattern of the plurality of micro LED pairs 1000 may be determined based on the shape of the plurality of micro LED pairs 1000.

For example, as seen from above, the plurality of micro LED pairs 1000 may be disposed such that two squares partially overlap each other in a diagonal direction. In this case, as seen from above, the plurality of micro LED pairs 1000 may be disposed in the diagonal direction. A density of micro LED pairs 1000 disposed on the array module 200m may increase due to the above arrangement, and this is advantageous in securing a sufficient amount of light.

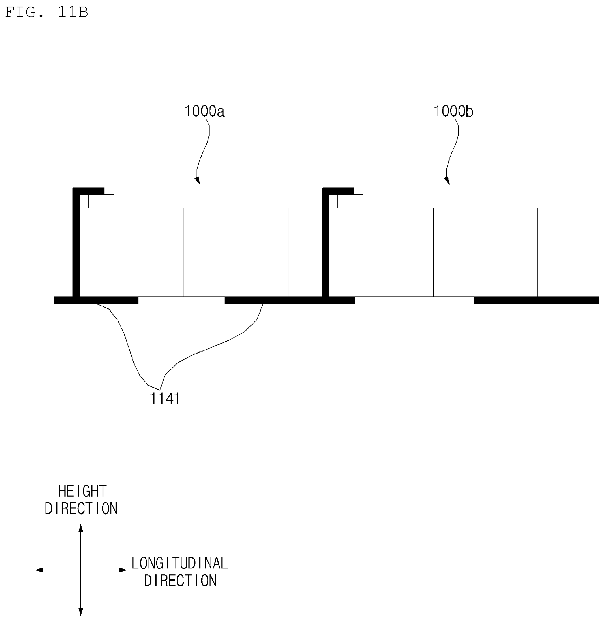

FIG. 11A illustrates an example of a plurality of micro LED pairs as seen from a direction from which light generated by the plurality of micro LED pairs is incident; and FIG. 11B illustrates an example of a first micro LED pair and a second micro LED pair among a plurality of micro LED pairs, which are seen from a direction of an arrow 1190 shown in FIG. 11A.

Referring to FIGS. 11A and 11B, the array module 200m may further include the base 911.

The base 911 may include a plurality of micro LED pairs 1000a and 1000b disposed thereon.

FIG. 11A shows an example in which six micro LED pairs are disposed on the base 911, but the number of micro LED pairs disposed on the base 911 is not limited.

The plurality of micro LED pairs may include a first micro LED pair 1000a and a second micro LED pair 1000b.

The first micro LED pair 1000a may be disposed on the base 911 in a direction diagonal to the second micro LED pair 1000b.

The second micro LED pair 1000b may be disposed on the base 911 in a direction 1130 diagonal to the first micro LED pair 1000b.

The array module 2000m may further include a wire 1140.

The wire 1140 may be connected to the plurality of micro LED pairs 1000a and 1000b.

The pattern of the wire 1140 may be determined by the shape of the plurality of micro LED pairs 1000a and 1000b.

The pattern of the wire 1140 may be determined by the arranged pattern of the plurality of micro LED pairs 1000.

The wire 1140 may include a sub-wire 1146 and a main wire 1141.

The sub-wire 1146 may be connected to each of the plurality of micro LED pairs 1000a and 1000b.

One end of the sub-wire 1146 may be connected to one of the plurality of micro LED pairs.

The other end of the sub-wire 1146 may be connected to the other of the plurality of micro LED pairs, or to the main wire 1141.

The sub-wire 1146 may extend in a longitudinal direction or a lateral direction of each of the plurality of micro LED pairs 1000a and 1000b.

The main wire 1141 may be connected to a plurality of sub-wires 1146.

The main wire 1141 may connect the plurality of sub-wires 1146 to form a contact point.

The main wire 1141 may be connected to the power supply unit 195.

The main wire 1141 may extend in parallel with a virtual line 1151 which connects first vertices of the plurality of micro LED pairs 1000a and 1000b.

A density of the micro LED pairs 1000 disposed on the array module 200m may increase due to the above-described wire pattern, and this is advantageous in securing a sufficient amount of light.

Meanwhile, the plurality of micro LED pairs shown in FIGS. 11A and 11B may be turned on or off all together.

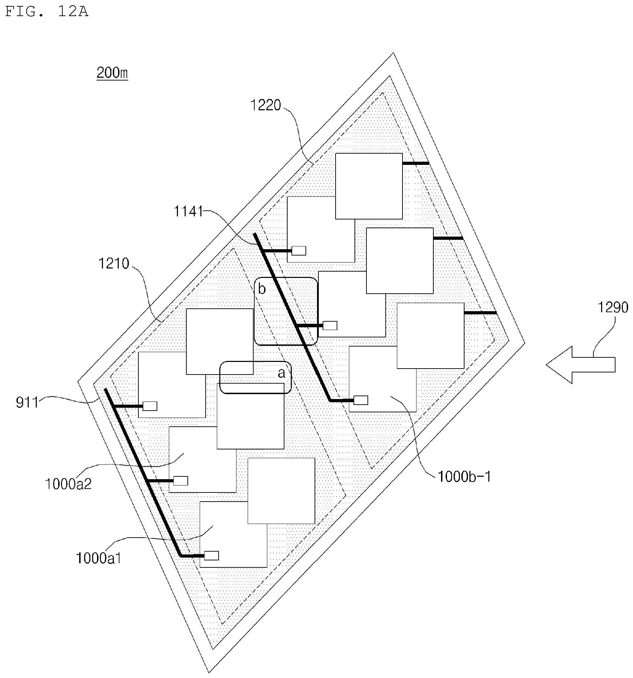

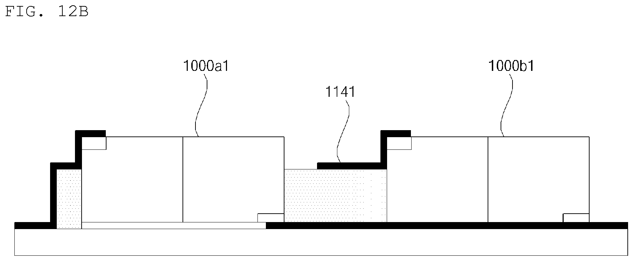

FIG. 12A illustrates an example of a plurality of micro LED pairs seen from a direction from which light generated by the plurality of micro LED pairs is incident; and FIG. 12B illustrates examples of a first micro LED pair and a second micro LED pair among a plurality of micro LED pairs, which are seen from a direction of an arrow 1290 shown in FIG. 12A.

Referring to FIGS. 12A and 12B, the array module 200m may include micro LED pairs which are classified into multiple groups.

The array module 200m may include a first group of micro LED pairs 1210 and a second group of micro LED pairs 1220.

An interval between micro LED pairs 1000a1 and 1000a2 in the first group may be smaller than an interval between the first group of micro LED pairs 1210 and the second group of micro LED pairs 1220.

The plurality of micro LED pairs in FIGS. 12A and 12B may be turned on or off on the basis of each individual group.

In order to turn on or off each group individually, a main wire 1141 needs to be positioned between the first group of micro LED pairs 1210 and the second group of micro LED pairs 1220.

Between the first group of micro LED pairs 1210 and the second group of micro LED pairs 1220, a space in which the main wire 1141 can be placed is needed. Thus, an interval between the first group of micro LED pairs 1210 and the second group of micro LED pairs 1220 is greater than an interval between the micro LED pairs 1000a1 and 1000a2 in the first group.

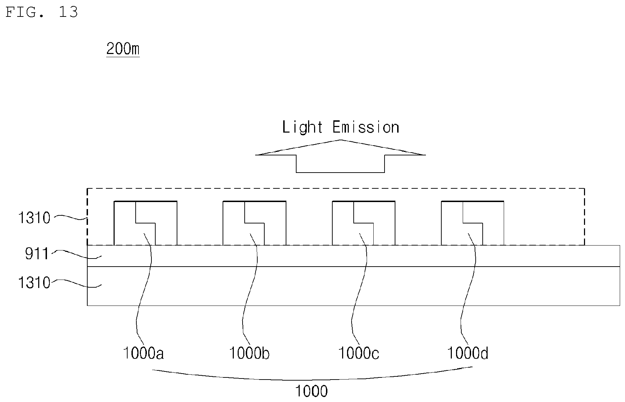

FIGS. 13 to 15 are diagrams illustrating an array module according to an embodiment of the present invention.

FIG. 13 is an example of a front view of an array module composed of a single layer.

Referring to FIG. 13, an array module 200m may include a base 911 and a first array 1310.

The base 911 may be formed of a material such as polyimide (PI).

In some embodiments, the base 911 may be a concept including a polyimide (PI) layer and a FCCL substrate disposed on the polyimide layer.

The first array 1310 may be disposed on the base 911.

For example, the first array 1310 may be configured as a plurality of micro LED pairs 1000 are transferred onto the base 911.

The first array 1310 may include a plurality of micro LED pairs 1000.

FIG. 13 illustrates an example in which there are four micro LED pairs 1000a, 1000b, 1000c, and 1000d, but the number of the micro LED pairs 1000 is not limited.

The array module 200m may further include a heat sink 1310.

The heat sink 1310 may be disposed below the base 911.

The heat sink 1310 may contact the base 911 to transfer heat generated by the plurality of micro LED pairs 1000.

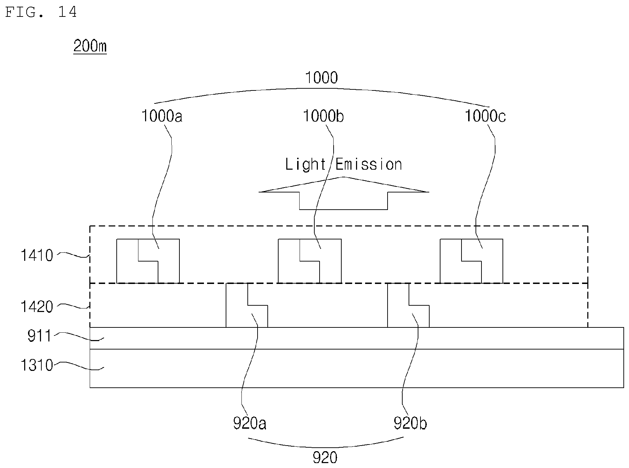

FIG. 14 is an example of a front view of an array module composed of two layers.

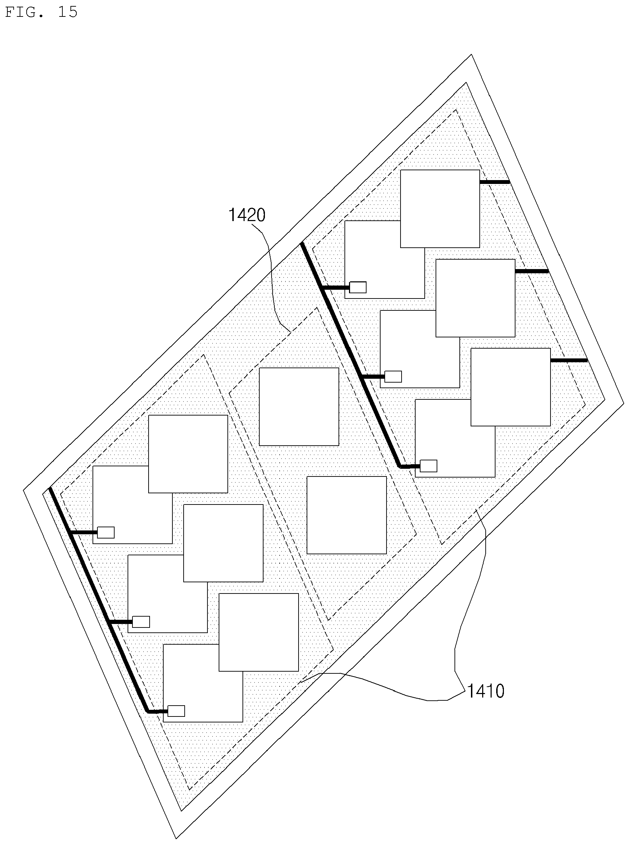

FIG. 15 is an example of a top view of an array module composed of two layers.

Referring to FIGS. 14 and 15, an array module 200m may include a base 911, a first array 1410, and a second array 1420.

The same description provided above may be applied to the base 911.

The first array 1410 may be disposed on the second array 1420.

A plurality of micro LED pairs 1000 may be disposed on the first array 1410.

The second array 1420 may be disposed on the base 911.

A plurality of micro LED chips 920 may be disposed on the second array 1420.

The arranged pattern of the plurality of micro LED chips 920 on the second array 1420 may be determined based on the arranged pattern of the plurality of micro LED pairs 1000.

For example, the plurality of micro LED chips 920 on the second array 1420 may be disposed not to overlap the plurality of micro LED pairs 1000 on the first array 1410 in a direction of light emission.

The direction of light emission may indicate a direction of outputting light generated by either or both of the first array 1410 and the second array 1420.

Meanwhile, in some embodiments, the plurality of micro LED pairs 1000 may be disposed on the second array 1410.

The first array 1410 and the second array 1420 may be turned on or off all together.

The first array 1410 and the second array 1420 may be electrically connected in series to each other.

For example, one of the plurality of LED pairs 1000 disposed on the first array 1410 may be connected in series to at least one of the plurality of micro LED chips 920 disposed on the second array 1420.

For example, one of the plurality of micro LED chips 920 disposed on the second array 1420 may be connected in series to at least one of the plurality of micro LED pairs 1000 disposed on the first array 1410.

In some embodiments, the first array 1410 and the second array 1420 may be electrically connected parallel to each other.

The first array 1410 and the second array 1420 may be turned on or off individually.

The plurality of micro LED pairs 1000 disposed on the first array 1410 may be electrically connected to a first positive electrode wire and a first negative electrode wire, and the plurality of micro LED chips 920 disposed on the second array 1420 may be electrically connected to a second positive electrode wire and a second negative electrode wire.

As above, the first array 1410 and the second array 1420 are connected to different pairs of a positive electrode wire a negative electrode wire, respectively, and thus, it is possible to control the first array 1410 and the second array 1420 individually.

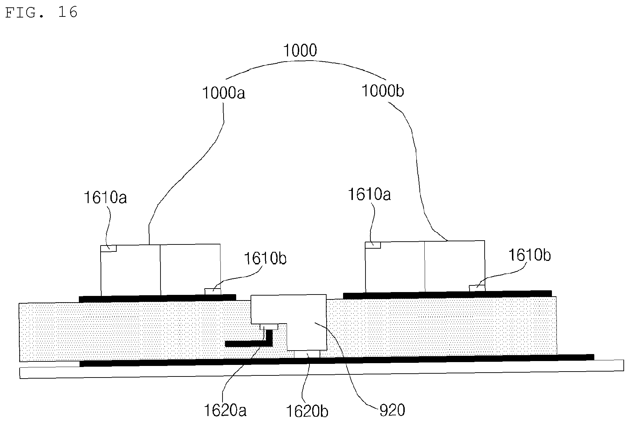

FIG. 16 is a diagram illustrating an example of how a plurality of micro LED pairs and electrodes of a plurality of micro LED chips are disposed, according to an embodiment of the present invention.

Referring to FIG. 16, each micro LED pair 1000 disposed on a first array 1410 may include a first (1a) electrode 1610 and a second (1b) electrode 1610b.

One of the first (1a) electrode 1610a and the second (1b) electrode 1610b is a positive electrode, and the other thereof is a negative electrode.

Each micro LED chip 920 disposed on the second array 1420 may include a first (2a) electrode 1620a and a second (2b) electrode 1620b.

One of the first (2a) electrode 1620a and the second (2b) electrode 1620b is a positive electrode, and the other thereof is a negative electrode.

The second (2b) electrode 1620b may be located underneath the bottom surface of a micro LED chip 920 disposed on the second array 1420.

The second (2b) electrode 1620b may be disposed on a wire to be in direct contact with the wire.

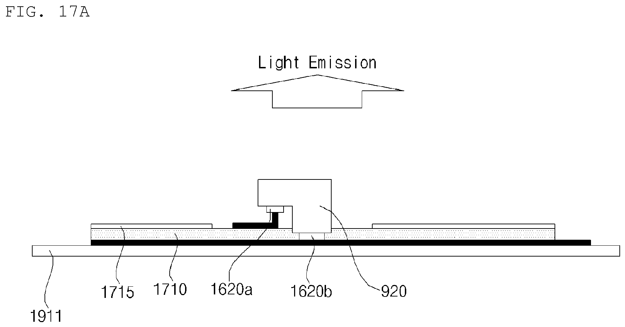

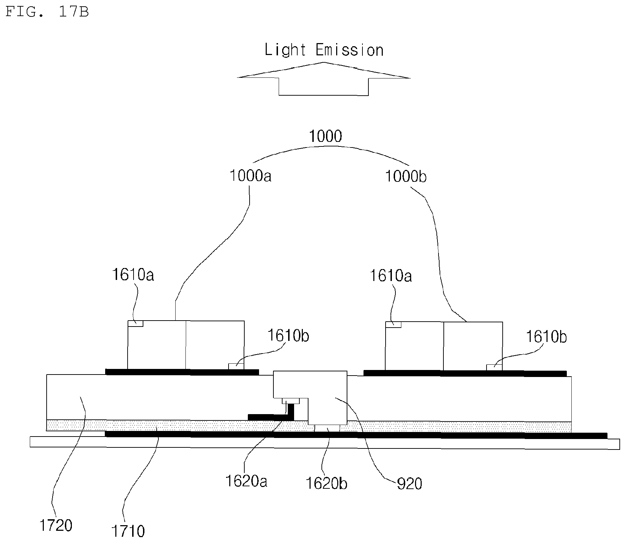

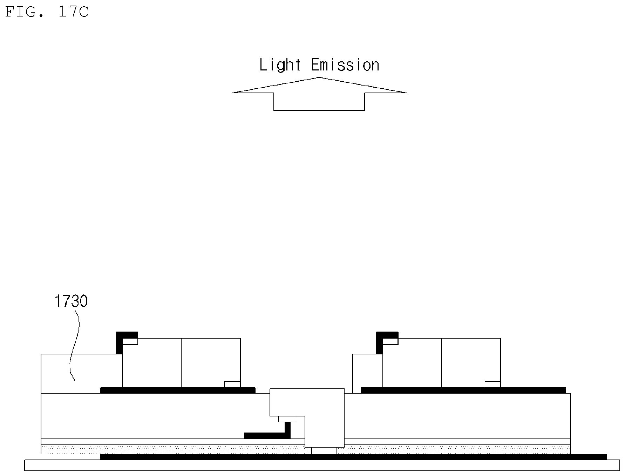

FIGS 17A to 17C are diagrams illustrating an array module according to an embodiment of the present invention.

Referring to FIGS. 17A to 17C, the array module 200m may further include a first insulation layer 1710, a reflective layer 1715, a second insulation layer 1720, and a third insulation layer 1730 individually or in combination thereof.

The first insulation layer 1710 may be disposed between the first (2a) electrode 1620a and the second (2b) electrode 1620b in a direction of light emission.

The first insulation layer 1710 may insulate the first (2a) electrode 1620a and the second (2b) electrode 1620b.

The first insulation layer 1710 may be formed of a material which is better at heat dissipation than the second insulation layer 1720 and the third insulation layer 1730.

In some embodiments, the first insulation layer 1710 may be formed of an opaque material. For example, the first insulation layer 1710 may be formed of a white material. In the case where the first insulation layer 1710 is formed of a white material, the first insulation layer 1710 may reflect light, incident from the first layer 1410, in the direction of light emission.

In some embodiments, the first insulation layer 1710 may be formed of a transparent material.

The reflective layer 1715 may be disposed on the first insulation layer 1710.

In some embodiments, the reflective layer 1715 may be disposed on the first insulation layer 1710 which is formed of an opaque material.

In some embodiments, the reflective layer 1715 may be disposed on the first insulation layer 1710 which is formed of a transparent material.

The second insulation layer 1720 may be disposed between the first insulation layer 1710 and the second (1b) electrode 1610b in the direction of light emission.

The second insulation layer 1720 may insulate the first array 1410 and the second array 1420.

The second insulation layer 1720 may be formed of a transparent material.

As the second insulation layer 1720 is formed of a transparent material, there is no loss in light which is reflected by the first insulation layer 1710 or the reflective layer 1715.

The second insulation layer 1720 may be disposed below a micro LED pair 1000 included in the first array 1410.

The third insulation layer 1730 may be disposed between the second insulation layer 1720 and the first (1a) electrode 1610a in a direction of light emission.

The third insulation layer 1730 may insulate the first (1a) electrode 1610a and the second (1b) electrode 1610b.

The third insulation layer 1730 may be formed of a transparent material.

As the third insulation layer 1730 may be formed of a transparent material, there is no loss in light which is reflected by the first insulation layer 1710 or the reflective layer 1715.

The height of the third insulation layer 1730 may be shorter than the height of the micro LED pair 1000 included in the first array 1410.

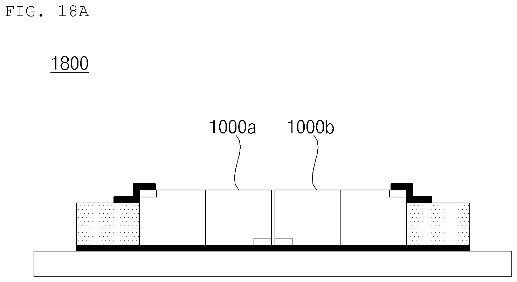

FIGS. 18A to 18D are diagrams illustrating an array module according to an embodiment of the present invention.

Referring to FIG. 18A, an array module 200m may include a first micro LED pair 1000a and a second micro LED pair 1000b.

The first micro LED pair 1000a and the second micro LED pair 1000b may be disposed such that electrodes of the same type face each other.

Meanwhile, the first micro LED pair 1000a and the second micro LED pair 1000b disposed such that electrodes of the same type face each other may be referred to as a micro LED pair module 1800.

For example, the first micro LED pair 1000a and the second micro LED pair 1000b may be disposed such that positive electrodes face each other. A positive electrode of the first micro LED pair 100a and a positive electrode of the second micro LED pair 1000b may be connected to the same wire, and a negative electrode of the first micro LED pair 1000a and a negative electrode of the second micro LED pair 1000b may be connected to different wires. In this case, by controlling a current flowing in the positive electrode of the first micro LED pair 1000a and a current flowing in the positive electrode of the second micro LED pair 1000b, individually, it is possible to turn on or off the first micro LED pair 1000a and the second micro LED pair 1000b individually.

For example, the first micro LED pair 1000a and the second micro LED pair 1000b may be disposed such that negative electrodes face each other. A negative electrode of the first micro LED pair 1000a and a negative electrode of the second micro LED pair 1000b may be connected to the same wire, and a positive electrode of the first micro LED pair 1000a and a positive electrode of the second micro LED pair 1000b may be connected to different wires. In this case, by controlling a current flowing in the positive electrode of the first micro LED pair 1000a and a current flowing in the positive electrode of the second micro LED pair 1000b, individually, it is possible to turn on or off the first micro LED pair 1000a and the second micro LED pair 1000b individually.

The array module 200m may include only one array.

A micro LED pair 1000, a micro LED pair module 1800, and a micro LED chip 250 may be disposed on the only one array individually or together.

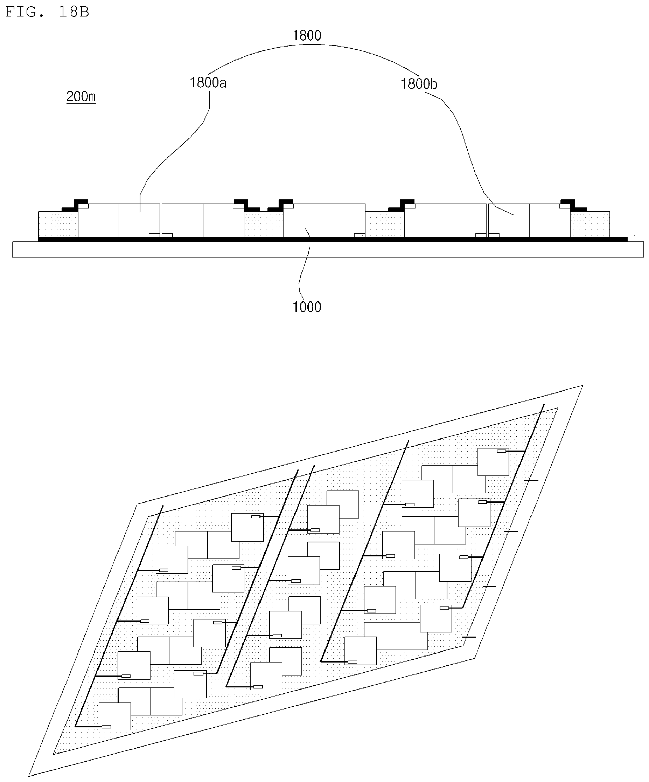

As illustrated in FIG. 18B, the array module 200m may include an array on which one or more micro LED pair modules 1800 and one or more micro LED pairs 1000 are disposed together.

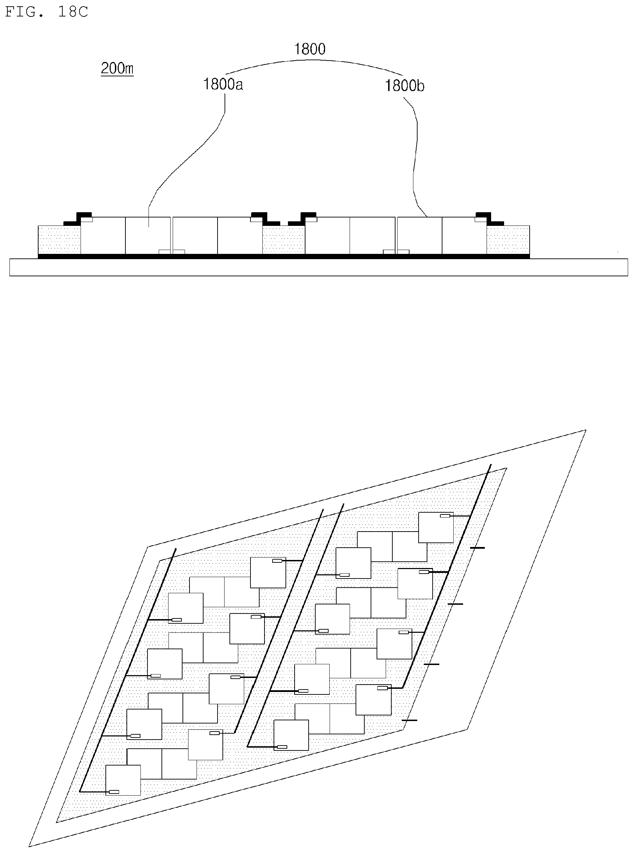

As illustrated in FIG. 18C, the array module 200m may include an array on which one or more micro LED pair modules 1800 are disposed.

In some embodiments, the array module 200m may include an array on which one or more micro LED pair modules 1800 and one or more micro LED chips 250 and one or more LED chips 920 are disposed together.

In some embodiments, the array module 200m may include an array on which one or more micro LED modules 1000 and one or more LED chips 250 are disposed together.

The array module 200m may include a first array and a second array.

A micro LED pair 1000, a micro LED pair module 1800, and a micro LED chip 250 may be disposed on the first array individually or together.

The micro LED pair 1000, the micro LED pair module 1800, and the micro LED chip 250 may be disposed on the second array individually or together.

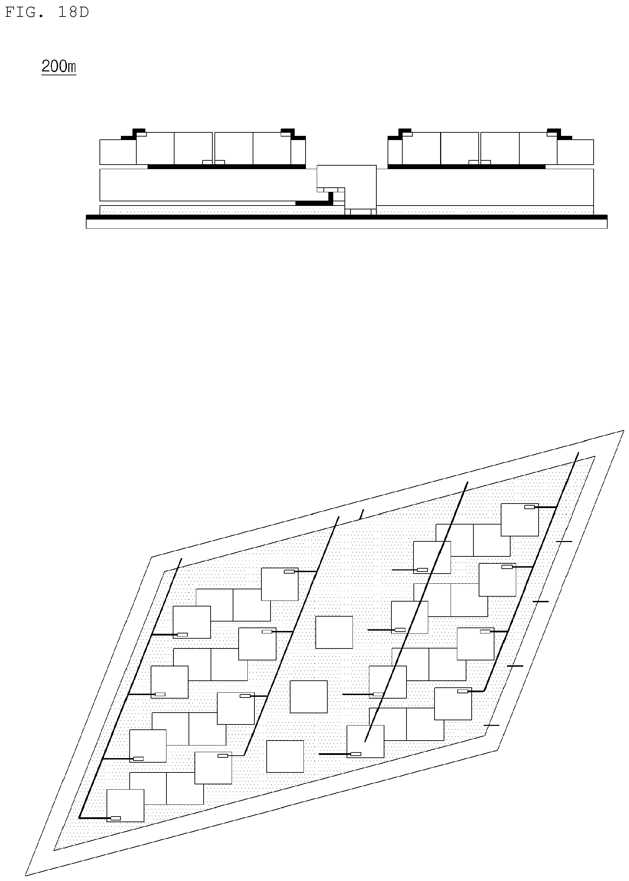

As illustrated in FIG. 18D, the array module 200m may include a first array on which one or more micro LED pair modules are disposed, and a second array on which one or more micro LED chips are disposed.

In some embodiments, the array module 200m may include a first array on which one or more micro LED pair modules are disposed, and a second array on which one or more micro LED modules are disposed.

In some embodiments, the array module 200m may include a first array on which one or more micro LED pair modules 1800 are disposed, and a second array on which one or more micro LED pair modules 1800.

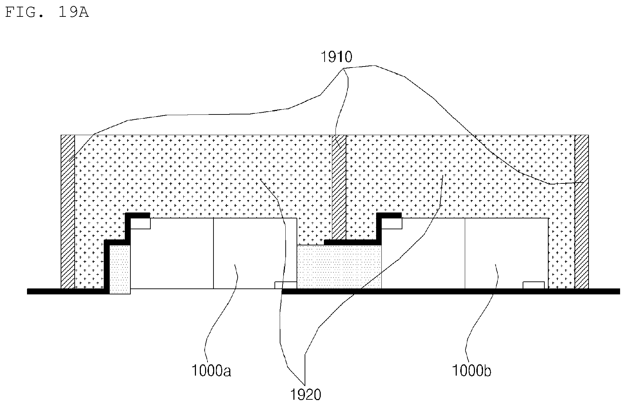

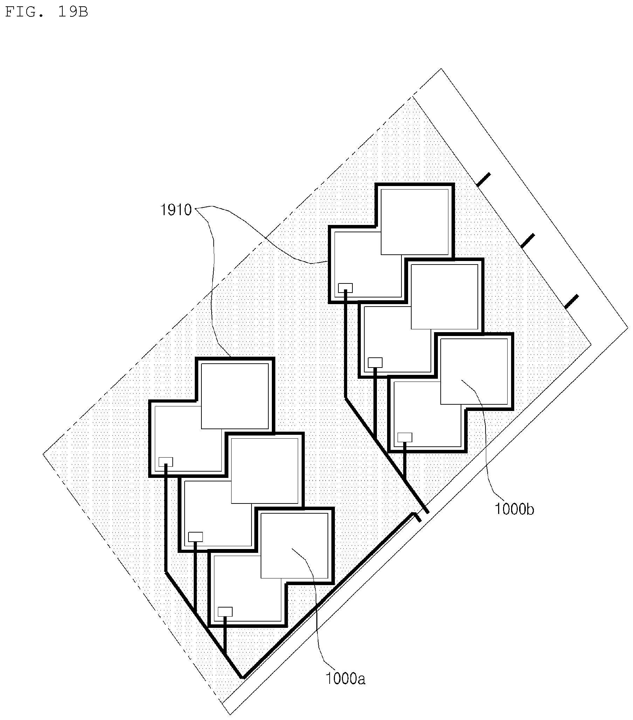

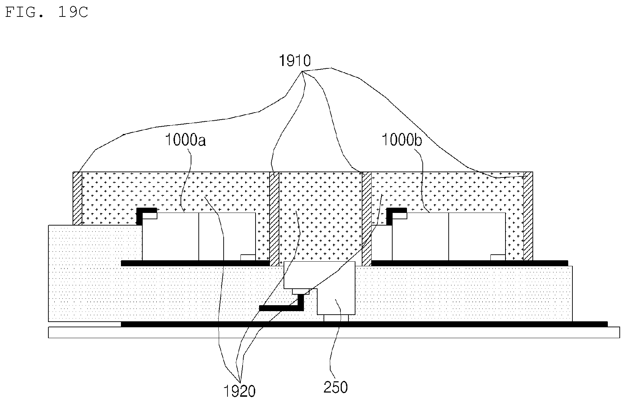

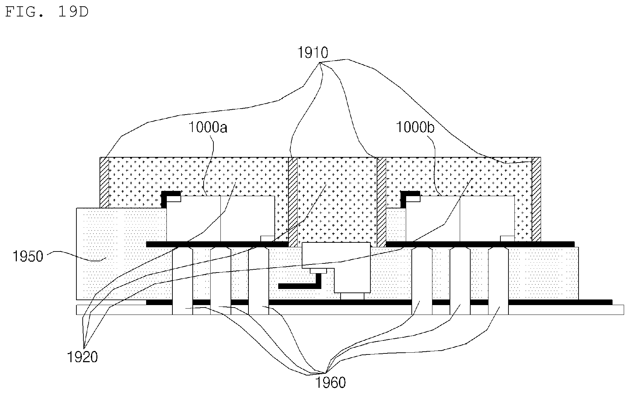

FIGS. 19A to 19D are diagrams illustrating an array module according to an embodiment of the present invention.

Referring to FIGS. 19A to 19D, the array module 200m may further include a partition structure 1910.

The partition structure 1910 may be formed to surround each micro LED pair 1000 in all directions.

The partition structure 1910 may guide light, generated by a plurality of micro LED pairs 1000, in a direction of light emission.

The partition structure 1910 may be composed of a plurality of partitions.

In some embodiments, the partition structure 1910 may be formed of a reflective material.

In some embodiments, the inside of each partition of the partition structure 1910 may coated with a reflective material.

The partition structure 1910 may define a space, in which light generated by the plurality of micro LED pairs 1000 is guided, to be distinguished from an outer space.

Meanwhile, the partition structure 1910 may be in the shape of a mesh which extends in a horizontal direction.

For example, a cross-section of the partition structure 1910 in a direction of light emission may be in the shape of a mesh.

The array module 200m may further include a phosphor 1920.

The phosphor 1920 may be coated on the inside of a space defined by the partition structure 1910.

For example, the phosphor 1920 may be coated on the inside of a light guide spaces defined by the partition structure 1910.

The array module 200m may further include an insulator 1950.

The insulator 1950 may include at least one of the first insulation layer 1710, the second insulation layer 1720, and the third insulation layer 1730 described above with reference to FIGS. 17A to 17C.

The insulator 1950 may be disposed below a plurality of micro LED pairs 1000.

The insulator 1950 may include one or more holes 1960 which accommodate a metal material therein.

The metal material may dissipate heat generated by the plurality of micro LED pairs 1000.

The present invention as described above may be implemented as code that can be written on a computer-readable medium in which a program is recorded and thus read by a computer. The computer-readable medium includes all kinds of recording devices in which data is stored in a computer-readable manner. Examples of the computer-readable recording medium may include a hard disk drive (HDD), a solid state disk (SSD), a silicon disk drive (SDD), a read only memory (ROM), a random access memory (RAM), a compact disk read only memory (CD-ROM), a magnetic tape, a floppy disc, and an optical data storage device. In addition, the computer-readable medium may be implemented as a carrier wave (e.g., data transmission over the Internet). In addition, the computer may include a processor or a controller. Thus, the above detailed description should not be construed as being limited to the embodiments set forth herein in all terms, but should be considered by way of example. The scope of the present invention should be determined by the reasonable interpretation of the accompanying claims and all changes in the equivalent range of the present invention are intended to be included in the scope of the present invention.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternatives uses will also be apparent to those skilled in the art.

## Claims

1. A lamp (100) for a vehicle (10), comprising an array module (200m),
wherein the array module (200m) comprises a plurality of micro Light Emitting Diode, LED, pairs (1000), and
wherein each of the plurality of micro LED pairs (1000) comprises:
a first micro LED chip (1010); and
a second micro LED chip (1020) having electrodes, one of which is in direct contact with one of electrodes in the first micro LED chips.

2. The lamp (100) according to claim 1,
wherein the first micro LED chip (1010) comprises a first positive electrode (1011) and a first negative electrode (1012),
wherein the second micro LED chip (1020) comprises a second positive electrode (1021) and a second negative electrode (1022), and
wherein the second positive electrode (1021) is in direct contact with one of the first positive electrode (1011) and the first negative electrode (1012), or the second negative electrode (1022) is in direct contact with one of the first positive electrode (1011) and the first negative electrode (1012).

3. The lamp (100) according to claim 2,
wherein the first positive electrode (1011) is positioned on a stepped portion which is at a first distance (1014) from the first negative electrode (1012) in a first direction of the first micro LED chip (1010),
wherein the second positive electrode (1021) is positioned on a stepped portion which is at the first distance (1014) from the second negative electrode in a first direction of the second micro LED chip (1020), and
wherein the first distance is half a length of the first micro LED chip in the first direction, and half a length of the second micro LED chip in the first direction.

4. The lamp (100) according to any one of claims 1 to 3, wherein an arranged pattern of the plurality of micro LED pairs (1000) is determined based on a shape of the plurality of micro LED pairs,
and/or
wherein the array module (200m) further comprises a base (911) on which the plurality of micro LED pairs (1000a, 1000b) is disposed and wherein the plurality of micro LED pairs (1000) comprises:
a first micro LED pair (1000a); and
a second micro LED pair (1000b), and
wherein the second micro LED pair (1000b) is disposed on the base (911) in a direction diagonal to the first micro LED pair (1000a).

5. The lamp (100) according to any one of claims 1 to 4,
wherein the array module (200m) further comprises a wire (1140) connected to the plurality of micro LED pairs (1000), and
wherein the wire (1140) comprises:
a sub-wire (1146) connected to each of the plurality of micro LED pairs (1000); and
a main wire (1141) connected to the sub-wire
and/or
wherein the sub-wire (1146) extends in a longitudinal direction or a lateral direction of each of the plurality of micro LED pairs (1000a, 1000b), and
wherein the main wire (1141) extends in parallel with a virtual line which connects first vertices of the plurality of micro LED pairs (1000a, 1000b)
and/or
wherein the array module (200m) comprises a first group of micro LED pairs (1210) and a second group of micro LED pairs (1220), and
wherein an interval (a) between micro LED pairs in the first group (1210) is smaller than an interval (b) between the first group of LED pairs and the second group (1220) of micro LED pairs.

6. The lamp (100) according to any one of claims 1 to 5,
wherein the array module (200m) comprises:
a first array (1410) on which the plurality of micro LED pairs (1000) is disposed; and
a second array (1420) on which a plurality of micro LED chips (920) is disposed, and
wherein an arranged pattern of the plurality of micro LED chips (920) on the second array (1420) is determined based on an arranged pattern of the plurality of micro LED pairs (1000).

7. The lamp (100) according to claim 6, wherein the plurality of micro LED chips (920) on the second array (1420) is disposed not to overlap the plurality of LED pairs disposed on the first array (1410) in a direction of light emission.

8. The lamp (100) according to claim 6 or 7, wherein any one of the plurality of micro LED chips (920) disposed on the second array (1420) is connected in series to at least one of the plurality of micro LED pairs (1000) disposed on the first array (1410)
or
wherein the plurality of micro LED pairs (1000) disposed on the first array (1410) is connected to a first positive electrode wire and a first negative electrode wire, and
wherein the plurality of micro LED chips (920) disposed on the second array (1420) is connected to a second positive electrode wire and a second negative electrode wire.

9. The lamp (100) according to any of claims 6 to 8,
wherein each of the plurality of micro LED pairs (1000) disposed on the first array (1410) comprises a first electrode (1610a) and a second electrode (1610b),
wherein each of the plurality of micro LED chips (920) disposed on the second array (1420) comprises a first electrode (1620a) and a second electrode (1620b), and
wherein the second electrode (1620b) of the respective micro LED chip (920) is located underneath a bottom surface of the respective micro LED chip (920) disposed on the second array (1420).

10. The lamp (100) according to claim 9, wherein the array module (200m) comprises a first insulation layer (1710) which is disposed between the first electrode (1620a) of the respective micro LED chip (920) and the second electrode (1620b) of the respective micro LED chip (920) in a direction of light emission
and/or
wherein the array module (200m) further comprises a second insulation layer (1720) which is disposed between the first insulation layer (1710) and the second electrode (1610b) of the respective micro LED pair (1000) in the direction of light emission, and which is formed of a transparent material
and/or
wherein the array module (200m) further comprises a third insulation layer (1730) which is disposed between the second insulation layer (1720) and the first electrode (1610a) of the respective micro LED pair (1000) in the direction of light emission, and which is formed of a transparent material.

11. The lamp (100) according to claim 10, wherein the first insulation layer (1710) is formed of an opaque material.

12. The lamp (100) according to claim 10 or 11, wherein the array module (200m) further comprises a reflective layer (1715) disposed on the first insulation layer (1710)
or
wherein the array module (200m) further comprises a reflective layer (1715) disposed on the first insulation layer (1710), and
wherein the first insulation layer (1710) is formed of a transparent material.

13. The lamp (100) according to any one of claims 1 to 12,
wherein the array module (200m) comprises a first micro LED pair (1000a) and a second micro LED pair (1000b), and
wherein the first micro LED pair (1000a) and the second micro LED pair (1000b) are disposed such that electrodes of the same type face each other.

14. The lamp (100) according to any one of claims 1 to 13, wherein the array module (200m) further comprises a partition structure (1910) which surrounds each of the plurality of micro LED pairs (1000) in all directions to guide light generated by the plurality of micro LED pairs
and/or
wherein the array module (200m) further comprises a phosphor (1920) which is coated inside a space defined by the partition structure (1910).

15. The lamp (100) according to any one of claims 1 to 14,
wherein the array module (200m) further comprises an insulator (1950) disposed below the plurality of micro LED pairs (1000), and
wherein the insulator (1950) comprises at least one hole (1960) which accommodates a metal material.
